# EUROPEAN PATENT SPECIFICATION

(11) **EP 1 672 647 B1**
(45) Date of publication and mention of the grant of the patent: **27.04.2011**
(21) Application number: 04106609.3
(22) Date of filing: 15.12.2004
(51) Int. Cl.: G11C 29/00

(54) **A non-volatile memory device supporting high-parallelism test at wafer level**
Ein nichtflüchtiger Speicher mit Unterstützung von hochparallelem Test auf Waferebene
Mémoire non-volatile supportant un test hautement parallèle au niveu de plaquette

(43) Date of publication of application: 21.06.2006
(73) Proprietor: STMicroelectronics Srl, 20041 Agrate Brianza (MB) (IT); Hynix Semiconductor Inc., Ichon-si, Kyoungki-do 467-701 (KR)
(72) Inventor: Lomazzi, Guido, I-21040 Castronno (VA) (IT); Renna, Ilaria, I-20100 Milano (IT); Maccarrone, Marco, I-27030 Palestro (PV) (IT)
(74) Representative: W.P. Thompson & Co.

(56) References cited:
- US-A- 5 440 516
- US-A- 6 005 814
- US-A1- 2002 006 066
- US-A1- 2002 009 006
- US-A1- 2003 048 673

## Description

The present invention relates to the memory field. More specifically, the present invention relates to the testing of semiconductor memory devices.

The test of semiconductor devices, and particularly of non-volatile memory devices is a very critical activity. The object of any test process is of verifying that each device under analysis operates correctly according to its specifications. This is of the utmost importance for ensuring a high level of quality of the corresponding production process.

A typical example is that of memory devices of the flash type with a NAND architecture, which must guarantee a very high reliability (such as 100K operation cycles and 10 years of data retention). However, due to technology reasons, there is a not negligible number of cells of the memory device that can work properly for a certain number of cycles before failing. The basic physical phenomenon occurring is that any read, program and erase operation internally generates very high voltages that cause a significant stress on oxide layers of the memory cells. Indeed, the thickness of the oxide layers is chosen in order to guarantee product reliability; however, due to many different production problems, it is possible that target oxide thickness is not reached. Particularly, oxide layers should be made thinner then expected, but not so thin to break up as soon as a significant electric field is applied. Therefore, the breaking of such thin oxide layers will happen after 100-1K erase-program cycles. This phenomenon is getting more and more evident and dangerous with the technology scaling.

In order to detect the memory devices with thinner oxide layers (also called "early failing devices") it is not possible to apply voltages higher than the ones usually needed for standard operations. In fact, such high voltages might damage good oxide layers as well; moreover, their generation would involve a significant waste of area of a silicon chip wherein the memory device is integrated.

A method to reduce the time required to perform the test process is of testing the memory device under stress conditions; a typical example is the so called burn-in test, which accelerates the break up of thinner oxide layers by having the electronic devices work for certain number of cycles at very high or very low temperature (simulating a long period of operation at room temperature).

In any case, the time required to perform the test process is very long. This drawback is particular acute in modern memory devices with high density; for example, it is possible to have memory devices of the NAND flash type with a capacity up to 4Gbit. Particularly, let us consider a memory device of 2Gbit, which is partitioned into 2K sectors that can be erased individually (typically in 2ms). Each sector consists of 64 pages each one of 2k bytes, which can be read/programmed individually; typically, each programming operation requires 300µs, plus the data insertion time (50ns every 1byte). Supposing to execute 1K erase-program cycles, it results that the total test process time is given by the following formulas:
- erase time: 2ms * 2K sectors * 1Kcycles = 4Ks ~ 68 minutes;
- program time: (64 pages * 2K sectors * 1Kcycles)*(300µs + (50ns * 2K)) = 51,2Ks ~ 14 hours.

A solution known in the art for reducing the time required by the test process is of executing parallel program/erase operations (that is, programming more than one page or erasing more than one sector simultaneously). However, the charge pump circuits that generate the high voltages necessary to execute the program operation have to be over-dimensioned, in such a way to support the higher load due to the parallel operations. Moreover, it is necessary to provide the memory device with additional logic circuits in order to manage the parallel erase/program operations. This cases an excessive waste of area on the chip.

A further solution is to execute a parallel testing (that is, testing more than one memory device at the same time) directly at the wafer level (before packaging). To execute such a parallel test, it is necessary to develop a suitable probe-card (a device that permits to contact the pads of each memory chip with corresponding probes). The main drawback of this solution is that each memory device normally has a number of pads equal to 15-16, so that a probe-card with a very high number of probes is required. However, this strongly increases the cost of the probe-card.

Another solution consists of simplifying the operations of the test process. However, the test process time is not significantly reduced. Moreover, in this case it is not possible to recreate the conditions that can cause the early failing of the memory devices exactly.

Built-in Self Testing (BIST) techniques are also known in the art. The BIST is a technique that has become increasingly popular in the last years, especially for testing complex semiconductor devices. For this purpose, the semiconductor device is provided with internal structures permitting the controllability and the observability of each pin and/or internal sequential element. A drawback of this solution is that it requires additional integrated structures (wasting area on the chip).

In any case, a common problem in the test process sphere is that a user may activate (accidentally or not) the test process when the memory device is in operation.

The US patent application US 2003/0048673 discloses an interface circuit to put an integrated circuit into a test mode and a decoder to decode one or more commands provided to the integrated circuit. The decoder includes sub-circuits, and each sub-circuit has a number of transistors coupled in series. The transistors coupled in series have control gates coupled to a clock signal or one of several inverted or non-inverted command signals representing a command. The control gates in each sub-circuit are coupled such that a unique pattern of the clock signal and the command signals will switch on all of the transistors to decode the command. Each sub-circuit is capable of decoding a single command. The sub-circuits have ratioed logic with more n-channel transistors than p-channel transistors. The decoder may be fabricated with a flexible placement or vias.

The present invention proposes a solution for the implementation of memory devices suitable to be tested with a high parallelism.

Particularly, an aspect of the present invention provides a non-volatile memory device as set forth in claim 1 and a process for producing the device as set forth in claim 6.

The characterizing features of the present invention are set forth in the appended claims. The invention itself, however, as well as further features and advantages thereof will be best understood by reference to the following detailed description, given purely by way of a non restrictive indication, to be read in conjunction with the accompanying drawings. In this respect, it is expressly intended that the figures are not necessary drawn to scale and that, unless otherwise indicated, they are merely intended to conceptually illustrate the structures and procedures described herein. Particularly:
Figure 1 illustrates a simple and schematic diagram of a memory device in which the solution according to an embodiment of the invention is applicable;
Figure 2 shows a functional diagram of a memory chip included in the memory device;
Figures 3a-3c show a flow chart relating to an illustrative implementation of a test process according to an embodiment of the invention;
Figure 4 illustrates a wafer of semiconductor material which memory chips are tested by means of a probe-card; and
Figure 5 shows a flow chart relating to an illustrative implementation of a simplified test process.

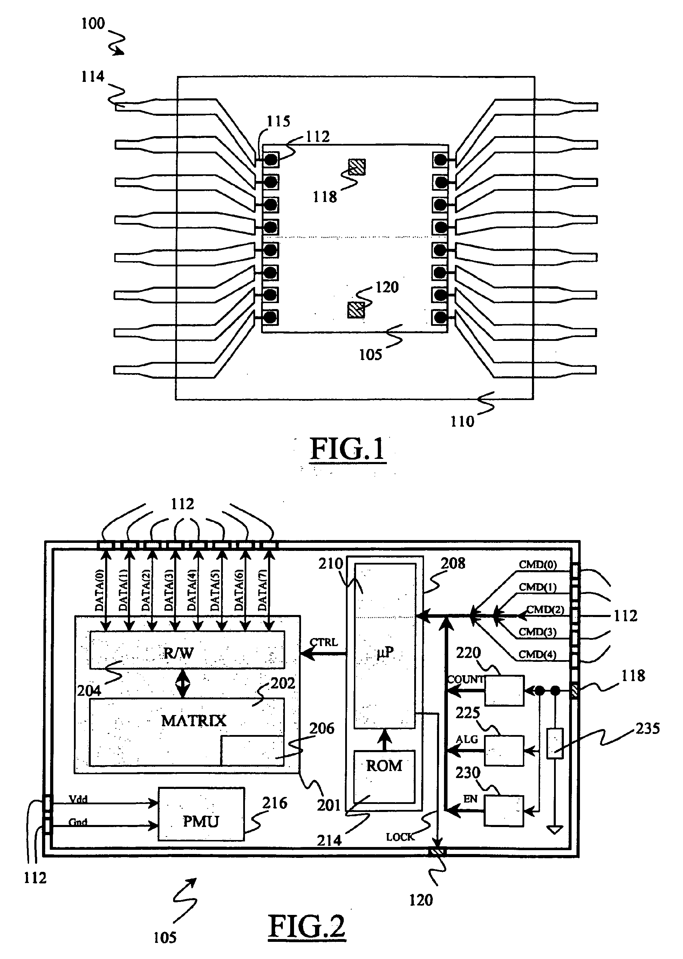

With references to the drawings, Figure 1 is a simplified and generic diagram of a non-volatile memory device 100 that includes a memory chip 105. The memory chip 105 may be embedded in a package 110 whose function is to protect the memory chip 105, to insulate it from the noise coming from other electronic devices, to evacuate heat generated during its functioning, and so on, as it is well known in the art. The memory chip 105 comprises a plurality of metalized emplacements (pads) 112. The pads 112 are connected to a corresponding plurality of terminals 114; for this purpose, each pad 112 is bonded with a corresponding terminal 114 by means of a wire 115, generally formed by aluminium or gold. The terminals 114 allow the memory chip 105 to receive input signals and power supply voltages from and to provide output signals to the outside of the memory device 100. Two extra pads 118 and 120 are used to control a test process of the memory chip 105 before its packaging (as will be more clear in the following); the extra pads 118 and 120 are not bonded with any terminal 114.

Turning now to Figure 2, a functional representation of the memory chip 105 is illustrated. Particularly, the core of the memory chip 105 consists of a block 201. Such memory block 201 includes a matrix 202 of memory cells for storing information (typically partitioned into sectors); in the example at issue, the memory cells of the matrix 202 are arranged according to a NAND architecture. The matrix 202 is connected to a read/write circuit 204, whose purpose is to select the addressed memory cells and to perform the desired operations on them (i.e., reading, writing or erasing). The read/write circuit 204 is connected to a control bus CTRL that provides corresponding signals CTRL necessary to command it properly (for convenience, in this document the signals and the corresponding physical lines are denoted with the same references). Eight bi-directional data lines DATA(0),...,DATA(7) are connected to the read/write circuit 204 in such a way to establish a link between the memory block 201 and the outside. The corresponding data signals DATA(0),...,DATA(7) can represent values to be stored in or read from the matrix 202, or addresses of selected memory cells of the matrix 202. An extra-area 206 of the matrix 202 is dedicated to store a number of test cycles to be performed during the test process of the memory chip 105.

The control bus CTRL originates from a control block 208, which consists of a microprocessor 210 connected to a ROM 214. The purpose of the microprocessor 210 is to drive the memory block 201 correctly by means of the control signals CTRL. The control signals CTRL are generated according to instructions stored in the ROM 214, which instructions are executed in response to command signals CMD(0),...,CMD(4); these command signals are provided by five unidirectional command lines CMD(0),...,CMD(4) grouped in a bus coming from the outside.

A power management unit PMU 216 receives two reference voltages (for example, a power supply voltage Vdd, and a ground voltage Gnd) from the outside through corresponding lines. The PMU 216 generates and distributes the correct power supply voltages to every circuital block of the memory chip 105.

The data lines DATA(0),...,DATA(7), the command lines CMD(0),...,CMD(4), and the two lines providing the voltage Vdd and the ground voltage are connected with the outside of the memory chip 105 by means of the pads 112 (bonded with corresponding terminals).

The microprocessor 210 receives commands (by means of the command lines CMD(0),...,CMD(4)) not only from the outside, but even from three further circuital blocks: a counter block 220, an algorithm selecting block 225 and a test enabling block 230. Particularly, the counter block 220 provides a counter signal COUNT (indicative of the number of test cycles to be executed), the algorithm selecting block 225 provides a select signal ALG (indicative of the test algorithm to be executed), and the test enabling block 230 provides an enabling signal EN (for starting the test process). Each of the blocks 220, 225 and 230 is connected to the extra pad 118 for receiving a corresponding signal from the outside.

The extra pad 118 is also connected to the ground line via a bleeder 235. The purpose of the bleeder 235 is to establish a low-resistance conductivity path toward the ground line, so as to avoid leaving the extra pad 118 floating. Finally, the other extra pad 120 is connected to a line coming from the control block 208 and carrying a signal LOCK (indicative of a completion of the test process).

The memory chip 105 can operate in two modes, and precisely: in a "burn-in mode", in which the memory chip 105 is subjected to the test process, and in a "standard mode", in which the memory chip 105 is used for storing information as usual. The operative mode of the memory chip 105 is selected according to the voltage applied to the extra pad 118; particularly, the memory chip 105 is in the burn-in mode or in the standard mode when the extra pad 118 is at the voltage Vdd or at the ground voltage, respectively. When the memory chip 105 is packaged, the memory chip 105 will be always in the standard mode. Indeed, the extra pad 118 is maintained at the ground voltage by the bleeder 235. In this condition, the extra pad 118 cannot be directly driven from the outside, since it is not bonded with any terminal. In this respect, it should be noted that the extra pad 118 actually has a connection with the outside (by means of the bleeder 235 that is connected to a terminal providing the ground voltage). However, the extra pad 118 cannot be driven to a voltage different from the reference one, and then it cannot be switched into the burn-in mode. Therefore, the extra pad 118 can be deemed not operatively accessible from the outside.

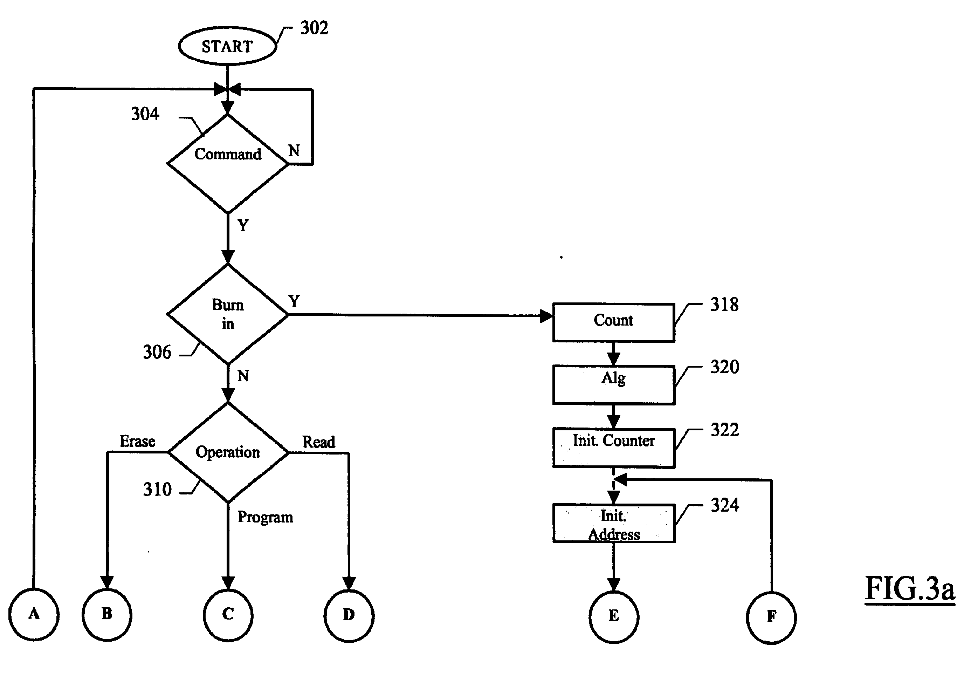

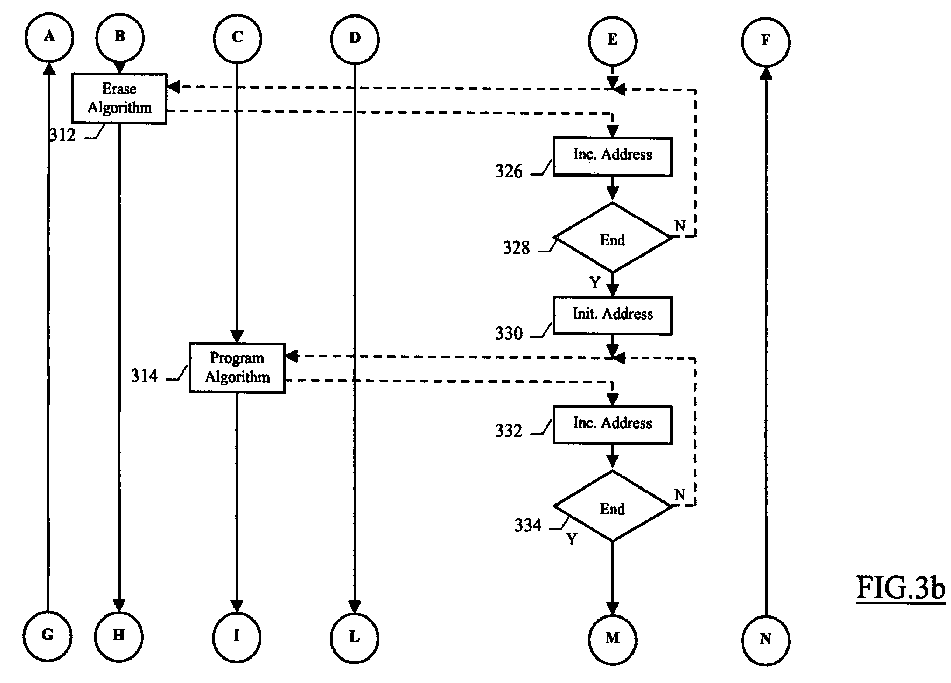

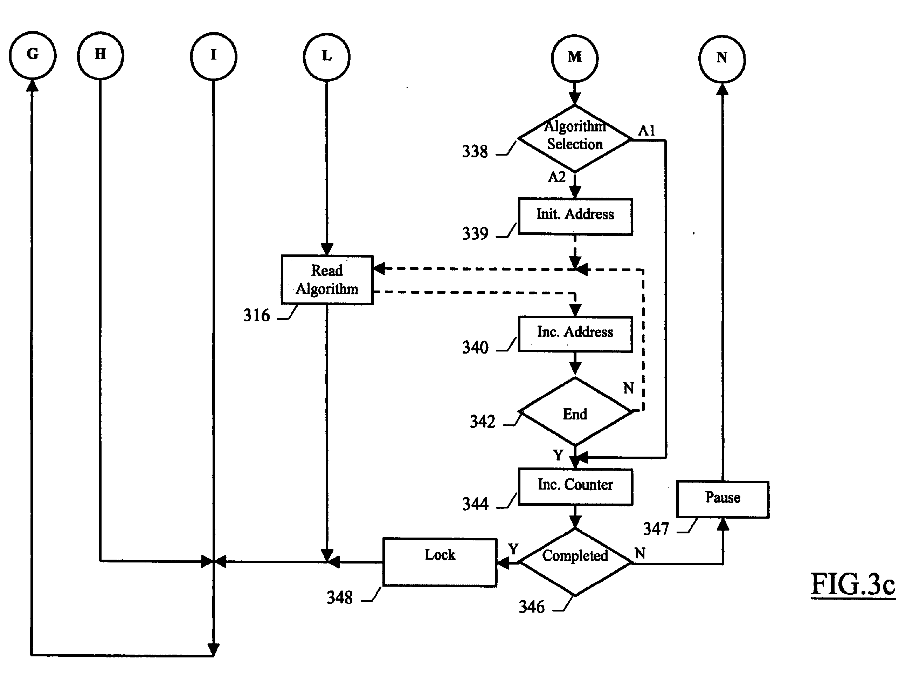

Referring to Figures 3a-3c, a flow chart 300 relating to an exemplary implementation of a functioning method of the memory device (according to an embodiment of the invention) is illustrated. The flow of activity begins at the start block 302, and then enters a waiting cycle 304. As soon as any command is received from the outside, the flow of activity proceeds to a decisional block 306. If the memory device is in the standard mode (i.e., corresponding extra pad at the ground voltage and then enabling signal EN deasserted), the method branches at the further decisional block 310 according to the received command signals CMD(0),...,CMD(4). Particularly, depending on the command signals CMD(0),...,CMD(4), the flow of activity continues to an erase algorithm block 312, to a program algorithm block 314, or to a read algorithm block 316.

If the flow of activity enters the erase algorithm block 312, the microprocessor drives the memory block to perform an erasing operation on a selected sector of the matrix by means of the control signals CTRL. The selection of the sector to be erased is determined by an address received from the outside by means of the data lines DATA(0),...,DATA(7) and interpreted by the read/write circuit 204.

On the other hand, if the flow of activity enters the program algorithm block 314, the microprocessor drives the memory block to perform a programming operation on a selected group of memory cells of the matrix (i.e., a page) by means of the control signals CTRL. The address of the selected page and the data to be stored therein is likewise received from the outside by means of the data lines DATA(0),...,DATA(7) and interpreted by the read/write circuit.

Finally, if the flow of activity enters the read algorithm block 316, the microprocessor drives the memory block to perform a reading operation on a selected page of the matrix by means of the control signals CTRL. The address of the selected page is received from the outside by means of the data lines DATA(0),...,DATA(7) and interpreted by the read/write circuit; the read values are then returned to the outside by means of the same data lines DATA(0),...,DATA(7).

Once the erase algorithm 312, the program algorithm 314, or the read algorithm 316 is completed, the flow of activity returns to the waiting cycle 304.

Referring back to the block 306, the memory device enters the burn-in mode in response to the application of the voltage Vdd to the extra pad (signal EN asserted). As a result, the flow of activity proceeds to the block 318; in this phase, a series of pulses of amplitude equal to the voltage Vdd is applied from the outside to the extra pad. The counter block determines the number of test cycles that will be performed during the test process accordingly; the counter block is structured in such a way to detect the end of the series of voltage pulses when no more voltage pulse is received after a certain period of time. For example, if the counter block receives n voltage pulses, it means that the test process must include the repetition of 2ⁿ test cycles. The counter block then provides the signal COUNT (indicating the number of test cycles 2ⁿ) to the microprocessor through the command lines CMD(0),...,CMD(4). In response thereto, the microprocessor stores the value representing the number of test cycles 2ⁿ into the corresponding extra-area of the matrix.

The flow of activity now proceeds to block 320, wherein another series of pulses of amplitude equal to the voltage Vdd (and with a predetermined duration) is applied from the outside to the extra pad. The algorithm selection block determines the desired algorithm that will be performed during the test process according to the frequency of the voltage pulses. For example, the algorithm selecting block chooses a first algorithm (A1) or a second algorithm (A2) when the frequency is lower or higher, respectively, than a threshold value; as described in detail in the following, each test cycle involves the erase-program or the erase-program-read of the whole memory matrix in the first algorithm A1 and in the second algorithm A2, respectively. The algorithm selection block then provides the signal ALG (indicating the selected algorithm) to the microprocessor through the command lines CMD(0),...,CMD(4).

Considering now block 322, the microprocessor initializes to zero a value m stored in a counter register (which indicates a current cycle of the test process in progress). Successively, the flow of activity proceeds to block 324, wherein an address register included in the microprocessor (indicating a current address of the matrix) is likewise reset to zero.

The flow of activity then returns to the erase algorithm block 312, wherein the microprocessor drives the memory block to perform the above-described erasing operation on a sector of the matrix; in this case, however, the address of the sector to be erased is forced by the microprocessor according to the content of its address register (pointing to the first sector at the beginning). Continuing to block 326, the value stored in the address register is incremented in such a way to point to a next sector of the matrix. A test is now made at block 328 to verify whether all the sectors of the matrix have been erased (that is, the value stored in the address register points to a last sector of the matrix, depending on its size). If not, the flow of activity returns to the erase algorithm block 312 to perform the erasing operation of the next sector.

Conversely, the method descends into the block 330, wherein the address register is reset again to zero. The flow of activity then returns to the program algorithm block 314, wherein the microprocessor drives the memory block to perform the above-described program operation on a page of the matrix. Even in this case, the address of the page to be programmed is forced by the microprocessor according to the content of its address register (pointing to the first page at the beginning); moreover, the microprocessor also forces predefined values to be stored in the selected page (for example, all 1). Continuing to block 332, the value stored in the address register is incremented in such a way to point to a next page of the matrix. A test is now made at block 334 to verify whether all the pages of the matrix have been programmed (that is, the value stored in the address register points to a last page of the matrix). If not, the flow of activity returns to the program algorithm block 314 to perform the programming operation of the next page.

The flow of activity now branches at block 338 according to the selected test process. Particularly, if the second algorithm (A2=erase-program-read) has been selected the address register is reset again to zero at block 339. The flow of activity then returns to the read algorithm block 316, wherein the microprocessor drives the memory block to perform the above-described read operation on a page of the matrix. Even in this case, the address of the page to be read is forced by the microprocessor according to the content of its address register (pointing to the first page at the beginning); moreover, the microprocessor intercepts the read values (so as to verify their correctness). Continuing to block 340, the value stored in the address register is incremented in such a way to point to a next page of the matrix. A test is now made at block 342 to verify whether all the pages of the matrix have been read. If not, the flow of activity returns to the read algorithm block 316 to perform the read operation of the next page.

Conversely, the test cycle is completed and the method descends into block 344. The same point is also reached from block 338 directly if the first algorithm (A1=erase-program) has been selected. In this phase, the microprocessor increments the counter register storing the current number of test cycles m. A test is now made at block 346 to determine whether the number of test cycles m already performed is equal to the value 2ⁿ stored in the extra-area of the matrix. If not, the flow of activity proceeds to the block 347, in which a pause is execute in such a way to permit at the circuital blocks of the memory device to conclude the operations engaged during the test cycle. Then, the flow of activity returns to block 324 for reiterating the test cycle.

Referring back to block 346, if the test process is completed the microprocessor 210 asserts the signal LOCK by bringing the corresponding extra-pad 120 to the voltage Vdd; this allows communicating that the test process has been completed to the outside. The memory chip then returns to the standby mode at the waiting cycle 304.

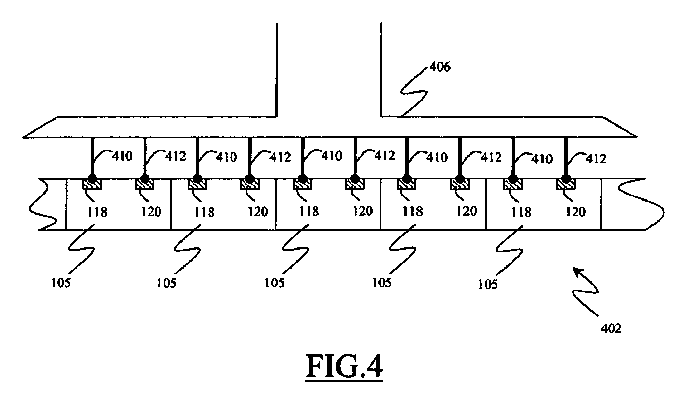

According to the proposed structure and algorithm, the test process can be operated directly at wafer level with a high parallelism, as showed in Figure 4. Referring to this Figure, a wafer of semiconductor material 402, including a plurality of memory chips 105, is illustrated during a burn-in test process. For this purpose, the wafer 402 is placed onto a chunk (not shown in the figure); a probe card 406 is then used to drive each memory chip 105 included in the wafer 402 in such a way to perform the burn-in test process. The probe card 406 includes two probes 410, 412 for each memory chip 105 (in addition to a probe for providing the ground voltage and a probe for providing the voltage Vdd, not shown in the Figure).
The purpose of the probe 410 is to contact the extra-pad 118, so as to provide the voltage corresponding to the enabling signal EN, to the counter signal COUNT, and the select signal ALG. Naturally, as the extra pad 118 is connected to a terminal providing the ground voltage via the corresponding bleeder, the probe 410 must have a high driving capability so as to force the desired voltage. The purpose of the probe 412 is instead to contact the extra-pad 120, so as to receive the signal LOCK indicating when the test process has been completed. It has to be noted that the extra-pad 120 of each memory chip 105 must have a pull-up capability stronger than the sum of all the pull-down capabilities of the others memory chips 105 on the wafer 402; otherwise, the probe card 406 would not be able to detect the completion of the test process on the corresponding memory chip 105.

Consequently, it is possible to perform the burn-in test process by using only two probes 410, 412 per memory chip 105. As a result, the probe card 406 can be strongly simplified (for the same number of memory chips 105); viceversa, the burn-in test process can be performed on a higher number of memory chips 105 simultaneously (for the same complexity of the probe card 406).

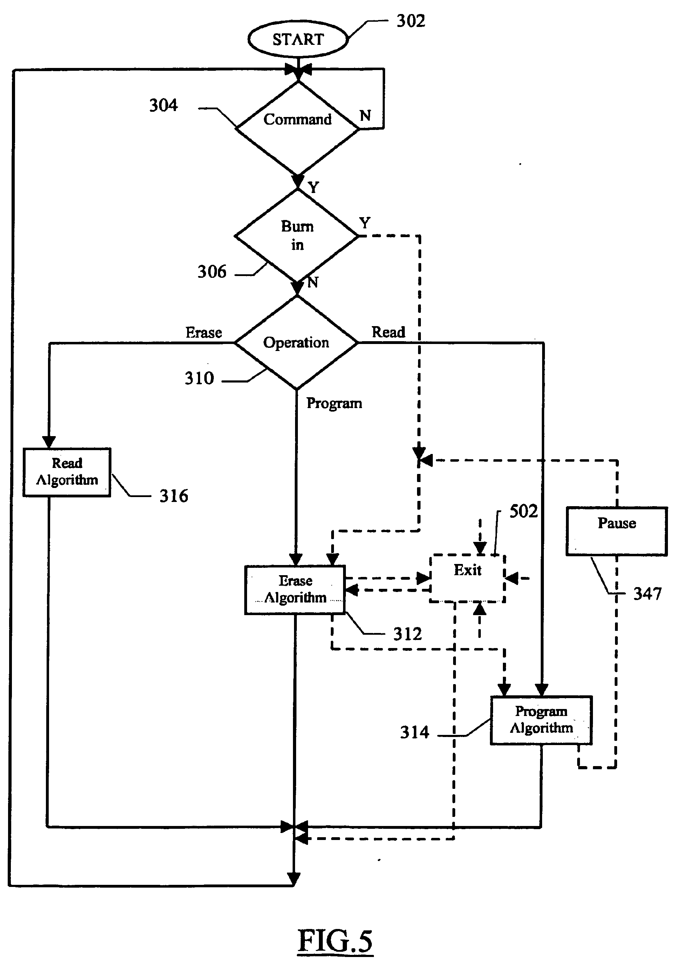

In Figure 5 an implementation of a simpler functioning method of the memory device is illustrated (the elements corresponding to the ones shown in Figures 3a-3c are denoted with the same references, and their explanation is omitted for the sake of brevity). This simpler method requires that the memory chip includes only one extra-pad. In this case, when the flow of activity arrives at the block 306, the memory device enters into the burn-in mode in response to the application of the voltage Vdd to the extra pad, and remains in this mode until the extra pad is turned back to the ground voltage (that is, until the probe card supplies the voltage Vdd to it) . Each test cycle is now composed by an erase operation and a program operation only. As soon as the extra-pad is returned to the ground voltage, the test process ends and the flow of activity exits the cycle by proceeding to the block 502. Before exiting the test process, the method returns to the erase algorithm block 312, thus performing a further erase operation (so as to leave the memory cells always erased).

It has to be noted that the number of repetitions of the test cycle is now determined by the time of application of the voltage Vdd to the extra-pad; this time can be calculated with a certain degree of accuracy once known the average time necessary to perform an erase operation followed by a program operation.

This simpler method does not permit to set the number of repetitions of the test cycle precisely. However, it necessitates a single extra-pad only, thereby allowing using a far simpler probe card (having only one probe per memory chip). Consequently, the burn-in test process can be performed on a higher number of memory chips simultaneously.

Naturally, in order to satisfy local and specific requirements, a person skilled in the art may apply to the solution described above many modifications and alterations. Particularly, although the present invention has been described with a certain degree of particularity with reference to preferred embodiment(s) thereof, it should be understood that various omissions, substitutions and changes in the form and details as well as other embodiments are possible; moreover, it is expressly intended that specific elements and/or method steps described in connection with any disclosed embodiment of the invention may be incorporated in any other embodiment as a general matter of design choice.

For example, even though in the preceding description reference has been made to a burn-in test of a memory device of the flash type with a NAND architecture, this is not to be intended as a limitation; indeed, the same concepts also apply to any other test process and/or any other non-volatile memory device.

Likewise, the extra pad can be replaced by any other access element (such as a photo detector).

It is not excluded that the test process could be enabled/disabled in response to different voltages.

Moreover, other packages are contemplated (for example, of the flip-chip type).

In addition, the completion of the test process can be communicated with an equivalent signal.

Likewise, the selection of the number of test cycles to be performed and/or the selection of the test algorithm to be used can be made by different interpretations of the toggling of corresponding signals.

It is contemplated that different test algorithms can be chosen (for example, involving erase-read-program-read cycles), or the simultaneous erasure of all the sectors.

Moreover, it will be apparent to those skilled in the art that the additional features not defined in the independent claims providing further advantages are not essential for carrying out the invention, and may be omitted or replaced with different features.

For example, the test process can be enabled/disabled with different signals.

Similar considerations apply if the chip is put on the market being not embedded in any package (for example, as a Known Good Die, or KGD); in this case, the extra-pad(s) are not listed among the pads to be bonded.

In any case, the use of the proposed solution at the level of single memory chips (already diced) is contemplated (even if far less advantageous).

As another example, in the case in which the number of repetitions of the test cycle is determined by the time of application of the predetermined voltage to the extra-pad, the solution can be implemented even without performing the further erase operation but terminating the test process immediately (even if it implies a worst control).

## Claims

1. A non-volatile memory device (100) including a chip (105) of semiconductor material embedded in a package (11.0), the chip including a memory (202) and control means (204, 210,214) for performing a programming operation (314), an erasing operation (312) and a reading operation (316) of the memory in response to corresponding external commands in a standard operating mode, the chip further including testing means (118, 120, 220,225, 230) for performing at least one test process including the repetition of at least one of said operations by the control means, and
a first access element (118) for enabling the testing means, the non-volatile memory device being **characterised by** the first access element (118) being operatively inaccessible from outside the package, each test process including a predefined number of repetitions of the at least one operation, the chip further including means for storing the predefined number (206), means for measuring a current number of repetitions, and means (210) for terminating the test process when the current number reaches the predefined number, the chip further including means (220) for setting the predefined number according to a first signal applied to the first access element (118), and the means for setting including means (220) for determining the predefined number according to the length of a sequence of toggling of the first signal.

2. The non-volatile memory device (100) of claim 1, wherein the testing means is disabled in response to the application of a first voltage to the first access element (118) and is enabled in response to the application of a second voltage to said first access element.

3. The non-volatile memory device (100) of claim 1 or claim 2, wherein the chip includes a second access element (120) for providing an indication of the completion of the test process.

4. The non-volatile memory device (100) of any claim from 1 to 3, wherein the at least one test process consists of a plurality of different test processes, the chip further including means (225) for selecting one of the test processes in response to a second signal applied to the first access element (118).

5. The non-volatile memory device of claim 4, wherein the means for selecting includes means (225) for determining the selected test process according to the frequency of a further sequence of toggling of the second signal.

6. A process for producing a non-volatile memory device (100) including the steps of:
providing a chip (105) of semiconductor material, the chip including a memory (202) and control element (204, 210, 214) for performing a programming operation (314), an erasing operation (312) and a reading operation (316) of the memory in response to corresponding external commands in a standard operating mode of the memory device, enabling testing means (118, 120, 220, 225, 230) of the chip using a first access element (118) to perform at least one test process including the repetition of at least one of said operations during a test mode, and embedding the chip into a package,
the process for producing a non-volatile memory device being **characterized by** the first access element (118) being operatively inaccessible from outside the package, each first test process including a predefined number of repetitions of the at least one operation, the process further including the steps performed inside the chip of storing the predefined number (206), measuring a current number of repetitions, terminating the test process when the current number reaches the predefined number, setting the predefined number according to a first signal applied to the first access element (118), and determining the predefined number according to the length of a sequence of toggling of the first signal.

7. The process of claim 6, wherein the process further includes the steps of:
applying a predetermined voltage to the first access element (118) for enabling the testing means, and
removing the predetermined voltage for disabling the testing means after a predetermined period.

8. The process of claim 6, wherein providing the chip of semiconductor material includes:
providing a wafer of semiconductor material; and
dicing the wafer of semiconductor material prior to embedding the chip into the package, wherein the enabling of the testing of the chip is performed prior to the dicing.

## Patentansprüche

1. Nichtflüclitige Speichervorrichtung (100) mit einem in einem Paket (110) eingebetteten Chip (105) aus Halbkitermaterial, wobei der Chip einen Speicher (202) und Steuermittel (204, 210, 214) zum Ausführen eines Programmiervorgangs (314), eines Löschvorgangs (312) und eines Lesevorgangs (316) des Speichers als Reaktion auf entsprechende externe Befehle in einem Standardbetriebsmodus umfasst, wobei der Chip weiter Prüfungsmittel (118, 120, 220, 225, 230) zum Ausführen mindestens eines Prüfverfahren, umfassend die Wiederholung mindestens eines der genannten Abläufe durch die Steuermittel und ein erstes Zugriffselement (118) zum Aktivieren der Prüfungsmitel umfasst, wobei die nichtflüchtige Speichervorrichtung **dadurch gekennzeichnet ist, dass** das erste Zugriffselement (118) von außerhalb des Pakets nicht wirksam zugreifbar ist, wobei die Prüfverfahren jeweils eine vordefinierte Zahl von Wiederholungen des mindestens einen Ablaufs umfassen, wobei der Chip weiter Mittel zum Speichern der vordefinierten Zahl (206), Mittel zum Messen einer aktuellen Zahl von Wiederholungen und Mittel (210) zum Beenden des Prüfverfahrens, wenn die aktuelle Zahl die vordefinierte Zahl erreicht, umfasst, wobei der Chip weiter Mittel (220) zum Einstellen der vordefinierten Zahl gemäß einem ersten, an das erste Zugriffselement (118) angelegten Signal umfasst und die Mittel zum Einstehen Mittel (220) zum Bestimmen der vordefinierten Zahl gemäß der Länge einer Sequenz des Hin- und Herschaltens des ersten Signals umfassen.

2. Nichtflüchtige Speichervorrichtung (100) nach Anspruch 1, wobei das Prüfungsmittel als Reaktion auf das Anlegen einer ersten Spannung an das erste Zugriffselement (118) deaktiviert wird und als Reaktion auf das Anlegen einer zweiten Spannung an das genannt erste Zugriffselement aktiviert wird.

3. Nichtflüchtige Speichervorrichtung (100) nach Anspruch 1 oder Anspruch 2, wobei der Chip ein zweites Zugriffselement (120) umfasst, um eine Anzeige der Vollendung des Prüfverfahren vorzusehen.

4. Nichtflüchtige Speichervorrichtung (100) nach einem der Ansprüche 1 bis 3, wobei das mindestens eine Prüfverfahren aus mehreren verschiedenen Prüfverfahren besteht, wobei der Chip weiter Mittel (225) zum Auswählen eines der Prüfverfahren als Reaktion auf ein an das erste Zugriffselement (118) angelegtes zweites Signal umfasst.

5. Nichtflüchtige Speichervorrichtung nach Anspruch 4, wobei das Mittel zum Auswählen Mittel (225) zum Bestimmen des ausgewählten Prüfverfahrens gemäß der Frequenz einer zweiten Sequenz des und Herschaltens des zweiten Signals umfasst.

6. Verfahren zum Herstellen eines nichtflüchtigen Speichervorrichtung (100), das folgende Schritte umfasst:
Bereitstellen eines Chips (105) aus Halbleitermaterial, wobei der Chip einen Speicher (202) und ein Steuerelement (204, 210, 214) zum Ausführen eines Programmiervorgangs (314), eines Löschvorgangs (312) und eines Lesevorgangs (316) des Speichers als Reaktion auf entsprechende externe Befehle in einem Standardbetriebsmodus der Speichervorrichtung umfasst;
Aktivieren von Prüfungsmitteln (118, 120, 220, 225, 230) des Chips unter Verwendung eines ersten Zugriffselements (118), um mindestens ein Prüfverfahren auszuführen, das die Wiederholung mindestens eines der genannten Abläufe während eines Prüfmodus umfasst; und Einbetten des Chips in ein Paket;
wobei das Verfahren zum Herstellen einer nichtflüchtigen Speichervorrichtung **dadurch gekennzeichnet ist, dass** das erste Zugriffselement (118) von außerhalb des Pakets nicht wirksam zugreifbar ist, wobei die Prüfverfahren jeweils eine vordefinierte Zahl von Wiederholungen des mindestens einen Ablaufs umfassen, wobei das Verfahren weiter die im Chip ausgeführten Schritte des Speicherns der vordefinierten Zahl (206), des Messens einer aktuellen Zahl von Wiederholungen, des Beendens des Prüfverfahrens, wenn die aktuelle Zahl die vordefinierte Zahl erreicht, des Einstellens der vordefinierten Zahl gemäß einem an das erste Zugriffselement (118) angelegten ersten Signal und des Bestimmens der vordefinierten Zahl gemäß der Länge einer Sequenz des Hin- und Hersehaltens des ersten Signals umfasst.

7. Verfahren nach Anspruch 6, wobei das Verfahren weiter folgende Schritte umfasst:
Anlegen einer vorherbestimmten Spannung an das erste Zugriffselement (118), um das Prüfungsmittel zu aktivieren, und
Entfernen der vorherbestimmten Spannung, um das Prüfungsmittel nach einem vorherbestimmten Zeitraum zu deaktivieren.

8. Verfahren nach Anspruch 6, wobei das Bereitstellen des Chips aus Halbleitermaterial Folgendes umfasst
Bereitstellen eines Wafers aus Halbleitermaterial; und
Dicing des Wafers aus Halbleitermaterial vor dem Einbetten des Chips in das Paket, wobei das Aktivieren der Prüfung des Chips vor dem Dicing ausgeführt wird.

## Revendications

1. Un dispositif à mémoire non volatile (100) comprenant une puce (105) d'un matériau semi-conducteur incorporée dans un boîtier (110), la puce comprenant une mémoire (202) et un moyen de commande (204, 210, 214) destiné à exécuter une opération de programmation (314), une opération d'effacement (312) et une opération de lecture (316) de la mémoire en réponse à des commandes externes correspondantes dans un mode de fonctionnement standard, la puce comprenant en outre un moyen de test (1 18, 120, 220, 225, 230) destiné à exécuter au moins un processus de test comprenant la répétition d'au moins une desdites opérations par le moyen de commande, et un premier élément d'accès (118) destiné à activer le moyen de test, le dispositif à mémoire non volatile étant **caractérisé par** le premier élément d'accès (118) étant opérationnellement inaccessible de l'extérieur du boîtier, chaque processus de test comprenant un nombre prédéfini de répétitions de la au moins une opération, la puce comprenant en outre un moyen de conserver en mémoire le nombre prédéfini (206), un moyen de mesurer un nombre actuel de répétitions et un moyen (210) de mettre fin au processus de test lorsque le nombre actuel atteint le nombre prédéfini, la puce comprenant en outre un moyen (220) de définir le nombre prédéfini selon un premier signal appliqué au premier élément d'accès (118), et le moyen de définition comprenant un moyen (220) de déterminer le nombre prédéfini selon la longueur d'une séquence de basculement du premier signal.

2. Le dispositif à mémoire non volatile (100) selon la Revendication 1, où le moyen de test est désactivé en réponse à l'application d'une première tension au premier élément d'accès (118) et est activé en réponse à l'application d'une deuxième tension audit premier élément d'accès.

3. Le dispositif à mémoire non volatile (100) selon la Revendication 1 ou ou la puce comprend un deuxième élément d'accès (120) destiné à fournir une indication de l'achèvement du processus de test.

4. Le dispositif à mémoire non volatile (100) selon l'une quelconque des Revendications 1 à 3, où le au moins un processus de test se compose d'une pluralité de différents processus de test, la puce comprenant en outre un moyen (225) de sélectionner l'un des processus de test en réponse à un deuxième signal appliqué au premier élément d'accès (118).

5. Le dispositif à mémoire non volatile selon la Revendication 4, où le moyen de sélection comprend un moyen (225) de déterminer le processus de test sélectionné selon la fréquence d'une autre séquence de basculement du deuxième signal.

6. Un processus de production d'un dispositif à mémoire non volatile (100), comprenant les opérations suivantes :
la fourniture d'une puce (105) d'un matériau semi-conducteur, la puce comprenant une mémoire (202) et un élément de commande (204, 210, 214) destiné à exécuter une opération de programmation (314), une opération d'effacement (312) et une opération de lecture (316) de la mémoire en réponse à des commandes externes correspondantes dans un mode de fonctionnement standard du dispositif à mémoire, l'activation d'un moyen de test (118, 120, 220, 225, 230) de la puce au moyen d'un premier élément d'accès (118) destiné à exécuter au moins un processus de test, comprenant la répétition d'au moins une desdites opérations au cours d'un mode test et l'incorporation de la puce dans un boîtier, le processus de production d'un dispositif à mémoire non volatile étant **caractérisé par** le premier élément d'accès (118) étant opérationnellement inaccessible de l'extérieur du boîtier, chaque processus de test comprenant un nombre prédéfini de répétitions de la au moins une opération, le processus comprenant en outre les opérations exécutées à l'intérieur de la puce de conservation en mémoire du nombre prédéfini (206), de mesure d'un nombre actuel de répétitions, de mise fin au processus de test lorsque le nombre actuel atteint le nombre prédéfini, de définition d'un nombre prédéfini selon un premier signal appliqué au premier élément d'accès (118) et de détermination du nombre prédéfini selon la longueur d'une séquence de basculement du premier signal.

7. Le processus selon la Revendication 6, où le processus comprend en outre les opérations suivantes ;
l'application d'une tension prédéterminée au premier élément d'accès (118) de façon à activer le moyen de test, et
la suppression de la tension prédéterminée de façon à désactiver le moyen de test après une période prédéterminée.

8. Le processus selon la Revendication 6, où la fourniture de la puce d'un matériau semi-conducteur comprend :
la fourniture d'une tranche d'un matériau semi-conducteur, et
le découpage en dés de la tranche d'un matériau semi-conducteur avant l'incorporation de la puce dans le boîtier, où l'activation des tests de la puce est exécutée avant le découpage en dés.
